# EUROPEAN PATENT APPLICATION

(11) **EP 2 407 499 A1**
(43) Date of publication of application: **18.01.2012**
(21) Application number: 10750795.6
(22) Date of filing: 08.03.2010
(51) Int. Cl.: C08G 61/12, G01J 1/02, H01L 29/786, H01L 51/05, H01L 51/30, H01L 51/42

(54) **FLUOROPOLYMER AND THIN ORGANIC FILM COMPRISING SAME**

(30) Priority: 11.03.2009 JP 2009058739
(71) Applicant: Sumitomo Chemical Company, Limited, Tokyo 104-8260 (JP); Osaka University, Suita-shi Osaka 565-0871 (JP)
(72) Inventor: IE Yutaka, Suita-shi Osaka 565-0871 (JP); NITANI Masashi, Suita-shi Osaka 565-0871 (JP); ASO Yoshio, Suita-shi Osaka 565-0871 (JP); UEDA Masato, Tsukuba-shi Ibaraki 305-0046 (JP)
(74) Representative: Duckworth, Timothy John
(86) International application number: PCT/JP2010/053805
(87) International publication number: WO 2010/104042

(57) **Abstract**

An object of the invention is to provide a fluorine-containing polymer that is superior in both stability against doping of oxygen and solubility in an organic solvent. The invention provides a fluorine-containing polymer including a structure represented by formula (I) in a repeating unit. 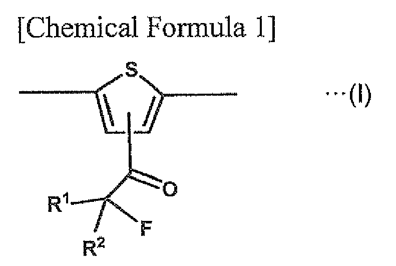 wherein R¹ and R² are the same or different and each mean a hydrogen atom, a halogen atom, or a monovalent group.

## Description

### Technical Field

The present invention relates to a fluorine-containing polymer and an organic thin film using the same, as well as an organic thin film element, an organic thin film transistor, an organic solar cell and a photosensor that comprise the organic thin film.

### Background Art

An application of a thin film containing an organic material having electric charge (electron or hole) transport ability to an organic thin film element, such as an organic thin film transistor, an organic solar cell, and a photosensor, has been looked forward, and an organic p-type semiconductor (with a hole transport property) and an organic an n-type semiconductor (with an electron transport property) using such an organic material are under development.

As an organic p-type semiconductor material a compound having a thiophene ring, such as oligothiophene and polythiophene, is expected to have a high hole transport property, because it can take a stable radical cation state. Especially, polythiophene having a side chain with long chain length is anticipated to be able to transport holes more efficiently because of its longer conjugation length. As such polythiophene, poly(3-alkyl thiophene) and poly(3-alkyl-4-fluorothiophene) have been proposed (Patent Literature 1, Non Patent Literature 1).

### Citation List

### Patent Literature

Patent Literature 1:EP Patent Application No. 1279690

### Non Patent Literature

Non Patent Literature 1: H. Sirringhous et. al., Synthetic Metals, vol. 102 (1999), p. 857

### Summary of Invention

### Technical Problem

According to a study by the present inventors, however, although poly(3-alkylthiophene) was superior in solubility in an organic solvent and able to be formed to a large area film by coating, an ionization potential was relatively low and therefore the film was vulnerable to doping of oxygen in the air and had tendency that a threshold potential or an off-state current could easily change, if the same was used in an organic thin film transistor. Consequently, it was difficult for the transistor to function stably over a long period of time. Meanwhile, poly(3-alkyl-4-fluorothiophene) was resistant to doping of oxygen, but its solubility in an organic solvent was inadequate.

From the viewpoint of establishing an organic thin film element using an organic semiconductor material, it is preferable that the organic semiconductor material not be susceptive to doping of oxygen and be formable by coating to a homogenous film.

Under such circumstances the present invention was made with an object to provide a fluorine-containing polymer, which is appropriate as an organic semiconductor material and superior in both stability against doping of oxygen and solubility in an organic solvent. Other objects are to provide an organic thin film to be yielded using the fluorine-containing polymer, an organic thin film element, an organic thin film transistor, an organic solar cell and a photosensor that comprise the organic thin film.

### Solution to Problem

To attain the objects, a fluorine-containing polymer according to the present invention is characterized by including a structure represented by formula (I) in a repeating unit: 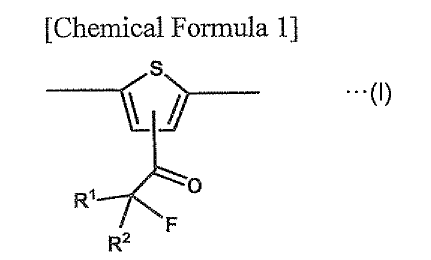 wherein R¹ and R² are the same or different and each mean a hydrogen atom or a monovalent group.

The fluorine-containing polymer is an organic semiconductor material, which is able to exhibit an excellent electric charge (hole) transport property, and have high stability against doping of oxygen as well as high solubility in an organic solvent. Although all the factors behind them have not been clarified completely, they are presumed as follows. Namely, since the fluorine-containing polymer has a thiophene ring recurrently in the main chain, it has a high conjugate property, and since it has a strongly electron-withdrawing fluorine atom in a side chain bonded to a thiophene ring, an ionization potential of the compound as a whole is high. Presumably as the result, it has an excellent hole transport property on one hand, and is strongly resistant to doping of oxygen, on the other hand. Further, the fluorine-containing polymer can maintain high solubility, although a fluorine atom is introduced, presumably because in the side chain a carbonyl group is included next to a carbon atom bonded by a fluorine atom.

Since the fluorine-containing polymer according to the present invention has high environmental stability with little influence of oxygen, an organic thin film using the same is similarly stable, and consequently an organic thin film element, which can have stable performance in the air, can be produced.

More preferably the fluorine-containing polymer according to the present invention includes further a structure represented by formula (II) in the repeating unit. Particularly, it is especially preferable that the structure represented by the formula (I) and the structure represented by the formula (II) should be included alternately. By inclusion of one or more such structures in addition to the structure represented by the formula (I), the fluorine-containing polymer according to the present invention can give the afore-described advantages more effectively. Moreover, by alternate inclusion of the structure represented by the formula (I) and the structure represented by the formula (II), the fluorine-containing polymer according to the present invention can have improved solubility in an organic solvent, and be superior in an electrical property and stability of the same, when an organic thin film is formed.

[Chemical Formula 2] -Ar¹- (II)

In the formula, Ar¹ means a C6 or higher divalent aromatic hydrocarbon group or a C4 or higher divalent heterocyclic group.

The Ar¹ in the formula (II) is preferably a group represented by formula (III). In this case, it is further preferable that Z¹ be a group represented by formula (ii). The fluorine-containing polymer having such structure has an especially good hole transport property: 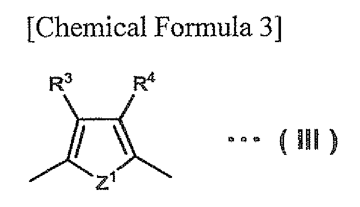 wherein R³ and R⁴ are the same or different and each mean a hydrogen atom or a monovalent group. R³ and R⁴ may be bonded together to form a ring. Z¹ means any of groups represented by the formulas (i), (ii), (iii), (iv), (v), (vi), (vii), (viii) and (ix) (hereinafter written as "(i)-(ix)"), wherein R⁵, R⁶, R⁷ and R⁸ are the same or different and each mean a hydrogen atom or a monovalent substituent. R⁵ and R⁶ may be bonded together to form a ring, and a group represented by the formula (iv) may be reversed from left to right.

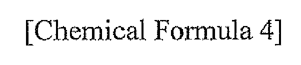

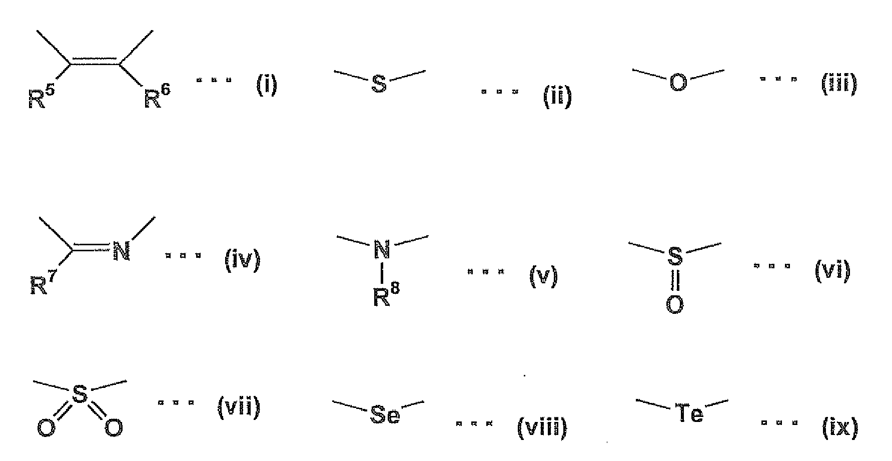

R¹ and R² in the formula (I) are the same or different and are each preferably a fluorine atom, a C1 to C20 alkyl group, or a C1 to C20 fluoroalkyl group. If R¹ and R² are of such groups, the stability against oxygen doping becomes still better and additionally the solubility in an organic solvent is further improved.

The present invention provides also an organic thin film containing the fluorine-containing polymer according to the present invention. Since an organic thin film according to the present invention contains the fluorine-containing polymer according to the present invention, it has a high hole transport property, and also good stability against oxygen doping. Further, since it can be formed into a film by coating, it can have homogenous properties even with a large area.

Further, the present invention provides an organic thin film transistor comprising a source electrode, a drain electrode, an organic semiconductor layer which forms a current pathway between the electrodes, and a gate electrode to control the amount of current through the current pathway, wherein the organic semiconductor layer comprises the organic thin film according to the present invention. Since the organic semiconductor layer comprises an organic thin film according to the present invention, such an organic thin film transistor can exert high mobility, and environmental stability of the same can be also high.

Further, the present invention provides an organic solar cell and a photosensor comprising the organic thin film according to the present invention. Since the organic thin film elements comprise the organic thin film according to the present invention, they can acquire satisfactorily an electric charge transport property required for operation of the respective elements to exhibit excellent properties, and also have high environmental stability.

### Advantageous Effects of Invention

The present invention can provide a fluorine-containing polymer, which is appropriate as an organic semiconductor material and superior in both stability against doping of oxygen and solubility in an organic solvent. Further, it can provide an organic thin film to be yielded using the fluorine-containing polymer, having a high hole transport property and high environmental stability with high resistance to oxygen doping, etc., as well as an organic thin film element, an organic thin film transistor, an organic solar cell and a photosensor.

### Brief Description of Drawings

[Figure 1] Figure 1 is a schematic sectional view of an organic thin film transistor according to the first embodiment.
[Figure 2] Figure 2 is a schematic sectional view of an organic thin film transistor according to the second embodiment.
[Figure 3] Figure 3 is a schematic sectional view of an organic thin film transistor according to the third embodiment.
[Figure 4] Figure 4 is a schematic sectional view of an organic thin film transistor according to the fourth embodiment.
[Figure 5] Figure 5 is a schematic sectional view of an organic thin film transistor according to the film embodiment.
[Figure 6] Figure 6 is a schematic sectional view of an organic thin film transistor according to the sixth embodiment.
[Figure 7] Figure 7 is a schematic sectional view of an organic thin film transistor according to the seventh embodiment.
[Figure 8] Figure 8 is a schematic sectional view of a solar cell according to an embodiment.
[Figure 9] Figure 9 is a schematic sectional view of a photosensor according to the first embodiment.
[Figure 10] Figure 10 is a schematic sectional view of a photosensor according to the second embodiment.
[Figure 11] Figure 11 is a schematic sectional view of a photosensor according to the third embodiment.

### Description of Embodiments

Appropriate embodiments with respect to the present invention will be described below in detail, according to need, referring to the drawings. In the drawings, the same reference sign will be assigned to the same element, and a duplicated description will be omitted. An expression about a positional relationship, such as top, bottom, left and right, will be based on the positional relationship in a drawing, unless otherwise indicated. Further, a dimensional ratio with respect to a drawing is not limited to the depicted ratio.

### [Fluorine-containing polymer]

A fluorine-containing polymer according to the present embodiment has a structure represented by the formula (I) in a repeating unit. The repeating unit constituting the fluorine-containing polymer may have solely a structure represented by the formula (I), or include additionally another structure as described hereinbelow. Since the fluorine-containing polymer has a thiophene ring structure recurrently in the main chain, conjugation planarity among the rings is good, and interaction among the molecules is strong; and moreover, since it has an α-fluoroketone structure (-C(=O)-C(F)<) bonded to a thiophene ring as a side chain, ionization potential can be increased and resistance to doping of oxygen can be improved. Therefore it can be used for an organic semiconductor, which is superior in a charge transport property and stable against oxygen doping. Further, since the fluorine-containing polymer has a side chain with the afore-described specific structure, it is superior also in solubility in an organic solvent and therefore can form from a prepared solution state a homogenous thin film, and produce an organic thin film having excellent properties thereof, and an organic thin film element using the same.

In the formula (I), R¹ and R² are the same or different and are each a hydrogen atom or a monovalent group, and are each preferably a fluorine atom, a C1 to C20 alkyl group, a C1 to C20 fluoroalkyl group, a C1 to C20 alkoxy group, or a C1 to C20 fluoroalkoxy group, and are each more preferably a fluorine atom, a C1 to C20 alkyl group, or a C1 to C20 fluoroalkyl group. Especially, from the viewpoint of improving the solubility in an organic solvent, it is appropriate that one or R¹ and R² is a fluorine atom, and the other is a C1 to C20 fluoroalkyl group.

Examples of the monovalent group for R¹ and R² include a linear or branched, saturated or unsaturated hydrocarbon group (especially a group of a low molecular chain), a C3 to C60 monovalent cyclic group (which may be a monocycle or a condensed ring, a carbocycle or a heterocycle, a saturated ring or an unsaturated ring, and may have a substituent or substituents), a hydroxyl group, an alkoxy group, an alkanoyloxy group, an amino group, an oxyamino group, an alkylamino group, a dialkylamino group, an alkanoylamino group, a cyano group, a nitro group, a sulfo group, an alkyl group substituted by a halogen atom or halogen atoms, an alkoxysulfonyl group (the alkoxy group may be substituted by a halogen atom or halogen atoms), an alkylsulfonyl group (the alkyl group may be substituted by a halogen atom or halogen atoms), a sulfamoyl group, an alkylsulfamoyl group, a carboxyl group, a carbamoyl group, an alkylcarbamoyl group, an alkanoyl group and an alkoxycarbonyl group.

Examples of the saturated hydrocarbon group include a linear, branched or cyclic C1 to C20 alkyl group; and a linear, branched or cyclic C1 to C12 alkyl group is preferable. Examples of the alkyl group include a methyl group, an ethyl group, an n-propyl group, an iso-propyl group, an n-butyl group, an iso-butyl group, a tert-butyl group, a 3-methylbutyl group, a pentyl group, a hexyl group, a 2-ethylhexyl group, a heptyl group, an octyl group, a nonyl group, a decyl group, a lauryl group, a cyclopropyl group, a cyclobutyl group, a cyclopentyl group, a cyclohexyl group, a cycloheptyl group, a cyclooctyl group, a cyclononyl group, and a cyclododecyl group. Further, as examples of a group containing the alkyl group in its structure (e.g. an alkoxy group, an alkylamino group, and an alkoxycarbonyl group), a group having the same groups as above as an alkyl group may be named.

Examples of the unsaturated hydrocarbon group include a vinyl group, a 1-propenyl group, an allyl group, a propargyl group, an isopropenyl group, a 1-butenyl group, and a 2-butenyl group.

Examples of the alkanoyl group include a formyl group, an acetyl group, a propionyl group, an isobutyryl group, a valeryl group, and an isovaleryl group. Further, as examples of a group containing the alkanoyl group in its structure (e.g. an alkanoyloxy group, and an alkanoylamino group), a group having the same groups as above as an alkanoyl group may be named. The C1 alkanoyl group means herein a formyl group, and a group containing the alkanoyl group in its structure means identically.

Further, examples of the halogen atom include a fluorine atom, a chlorine atom, a bromine atom and an iodine atom.

It is preferable that a fluorine-containing polymer according to the present embodiment have further one or more structures represented by the formula (II) in a repeating unit in addition to a structure represented by the formula (I), because a charge transport property, stability against oxygen doping, and solubility in a solvent are improved.

Ar¹ in the formula (II) is a C6 or higher divalent aromatic hydrocarbon group or a C4 or higher divalent heterocyclic group, which may further have a substituent or substituents.

A divalent aromatic hydrocarbon group here means a group consisting of a residual atomic group derived by removing 2 hydrogen atoms from a benzene ring or a condensed ring, and is preferably C6 to C60, and more preferably C6 to C20. The number of carbon atoms of the substituent is not counted in the number of carbon atoms. Examples of the condensed ring include a naphthalene ring, an anthracene ring, a tetracene ring, a pentacene ring, a pyrene ring, a perylene ring, and a fluorene ring. As the divalent aromatic hydrocarbon group is preferable a residual atomic group derived by removing 2 hydrogen atoms from a benzene ring, a pentacene ring, a pyrene ring, or a fluorene ring. Examples of the substituent which the divalent aromatic hydrocarbon group may possess include a halogen atom, a saturated or unsaturated hydrocarbon group, an aryl group, an alkoxy group, an aryloxy group, a monovalent heterocyclic group, an amino group, a nitro group, and a cyano group.

Similarly, a divalent heterocyclic group means a group consisting of a residual atomic group derived by removing 2 hydrogen atoms from a heterocyclic compound, and is preferably C4 to C60, and more preferably C4 to C20. The term "a heterocyclic compounds" here means an organic compound having a cyclic structure, which includes not only carbon atoms as constituting elements of the ring, but also a heteroatom, such as oxygen, sulfur, nitrogen, phosphorus, boron, and silicon, in the ring.

Examples of the divalent heterocyclic group include groups including residual atomic groups derived by removing 2 hydrogen atoms from thiophene, thienothiophene, dithienothiophene, thiazole, pyrrole, pyridine, and pyrimidine. Among others, groups including residual atomic groups derived by removing 2 hydrogen atoms from thiophene, thienothiophene, and thiazole are preferable. The divalent heterocyclic group may have a substituent or substituents, but in this case a carbon number of the substituent is not counted in a carbon number of the divalent heterocyclic group. Examples of the substituent include a halogen atom, a saturated or unsaturated hydrocarbon group, an aryl group, an alkoxy group, an aryloxy group, a monovalent heterocyclic group, an amino group, a nitro group, and a cyano group.

It is appropriate if Ar¹ in the formula (II) is a group including a residual atomic group derived by removing 2 hydrogen atoms from a condensed ring or a thiophene ring. Since this leads to existence of a thiophene ring as the structure represented by the formula (I) and a condensed ring or a thiophene ring as the structure represented by the formula (II), planarity of a π-conjugated structure is further improved, and as the result a molecule can take more easily a π-π stacking structure, so as to improve further the charge transport property.

Since, among others, a π-conjugated structure containing a thiophene ring can decrease an interplanar spacing of a π-π stacking structure, and therefore give a better effect to improve a charge transport property, a residual atomic group derived by removing 2 hydrogen atoms from a thiophene ring is especially suitable as Ar¹. From the viewpoint of improving the solubility in an organic solvent and also maintaining well the π conjugation planarity, Ar¹ preferably has a substituent or substituents.

As Ar¹ in the formula (II) a group represented by the formula (III) is also preferable. In the formula (III) R³, R⁴, R⁵, R⁶, R⁷ and R⁸ are the same or different and are each a hydrogen atom or a monovalent group, and as examples of the monovalent group, the same groups described above with respect to R¹ and R² may be named.

Z¹ is one of the groups represented by formulas (i) to (ix), is preferably any of groups represented by formulas (ii), (iii), (v), (viii) and (ix), is further preferably any of groups represented by formulas (ii), (iii) and (v), and is especially preferably a group represented by formula (ii). If a group represented by the formula (III) is a thiophene ring (Z¹ is a group of the formula (ii)), a furan ring (Z¹ is a group of the formula (iii)) and a pyrrole ring (Z¹ is a group of the formula (v)), and is especially a thiophene ring, a characteristic electrical property can be exhibited from the afore-described reasons or the like, and expression of a nonconventional novel electrical characteristic may be expected.

It is prerequisite for a fluorine-containing polymer according to the present embodiment to have a structure represented by the formula (I) in a repeating unit, and it is preferable to have a structure represented by the formula (I) and a structure represented by the formula (II) (preferably the formula (III)) in combination in the repeating unit. By selecting such a constitution, a variable range of solubility, and a mechanical, thermal or electronic property can be broadened.

The fluorine-containing polymer may contain in a repeating unit 2 or more structures represented by formula (I), and 2 or more structures represented by formula (II) (preferably formula (III)).

In the fluorine-containing polymer the structure represented by the formula (I) and the structure represented by the formula (II) (preferably the structure represented by the formula (III)) are contained preferable at the ratio of the former 100 mol / the latter 10 to 1000 mol, more preferably the former 100 mol / the latter 25 to 400 mol, and further preferably the former 100 mol / the latter 50 to 200 mol.

As the fluorine-containing polymer compounds represented by the formulas (IV) to (IX) are appropriate. Such fluorine-containing polymer gives an especially good charge transport property, and also high stability against oxygen doping, and even has excellent solubility.

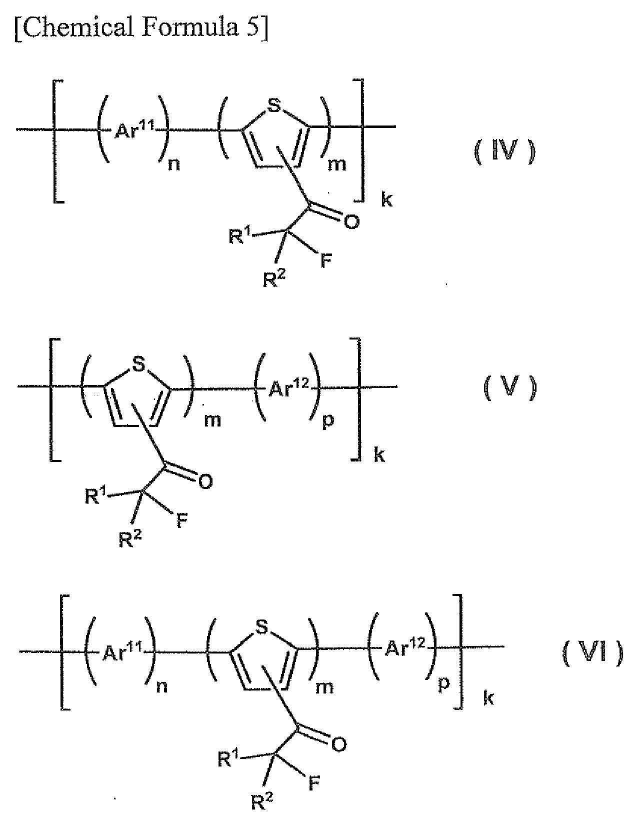

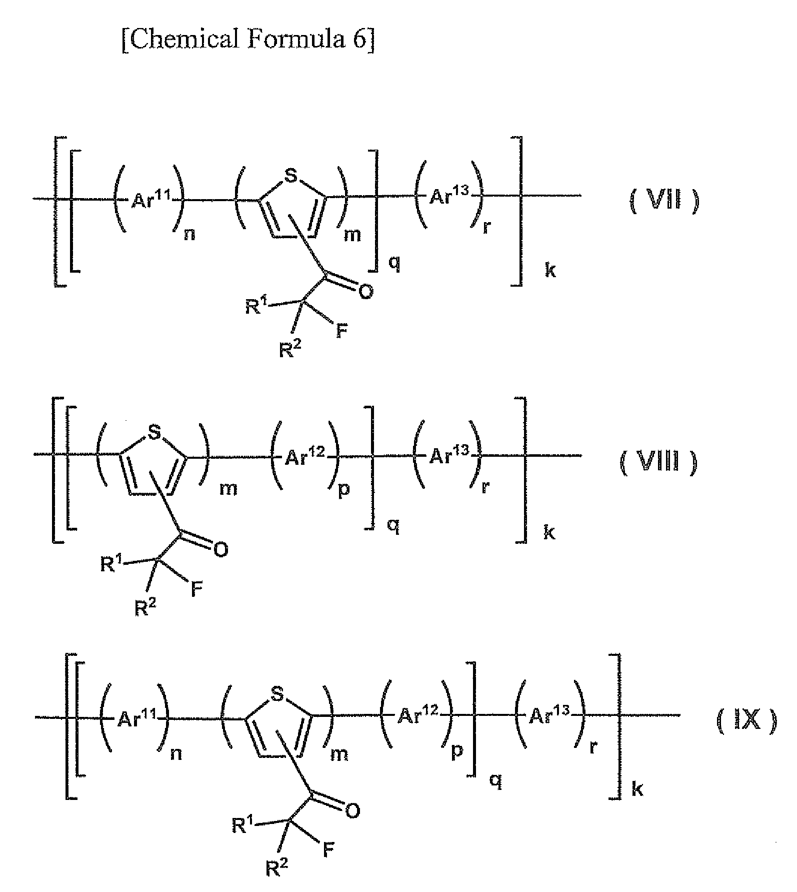

R¹ and R² in the formula (IV) to (IX) have the same meanings as defined hereinabove. Ar¹, Ar¹² and Ar¹³ are the same or different and are each the same as the afore-described Ar¹, and appropriate groups therefor are also the same as Ar¹. m is an integer of 1 to 6. n and p are the same or different and are each an integer or 1 to 6, and preferably n + p is 6 or less. q and r are the same or different and are each an integer of 1 to 10, preferably an integer of 1 to 6, and more preferably an integer of 1 to 3. k means the degree of polymerization and is preferably an integer of 2 to 500. If a plurality of any of R¹ R², Ar¹¹, Ar¹² and Ar¹³ is present in a molecule, groups expressed by the same reference sign may be the same or different.

There is no particular restriction on a terminal group of a fluorine-containing polymer. If, however, a fluorine-containing polymer is used as an organic thin film, and an intact polymerization active group remains at the terminus, and when an organic thin film element is produced, it is possible that a property or durability may be compromised. Consequently, if a terminal group is a polymerization active group, it may be protected by a stable group.

Examples of the terminal group include a hydrogen atom, a fluorine atom, an alkyl group, an alkoxy group, an acyl group, an aminoketo group, an aryl group, a monovalent heterocyclic group (a part or all of hydrogen atoms bonded to the group may be substituted by a fluorine atom), groups having an α-fluoroketone structure, and other electron donating groups and electron attracting groups.

Particularly from the viewpoint of improving a charge transport property of a fluorine-containing polymer, a fluoroalkyl group, a fluoroalkoxy group, a fluoroaryl group, a group having an α-fluoroketone structure and other electron attracting groups are preferable; and a group whose hydrogen atoms are entirely substituted by fluorine atoms, such as a perfluoroalkyl group, a perfluoroalkoxy group, and a perfluorophenyl group, is especially preferable. Further as a terminal group, that having a conjugated bond continuing to a conjugate structure of the main chain of a fluorine-containing polymer is also preferable. An example is a group having a conjugate structure bonded to an aryl group or a heterocyclic group in the main chain via a carbon-carbon bond.

Examples of an appropriate fluorine-containing polymer include compounds represented by formulas (1) to (9).

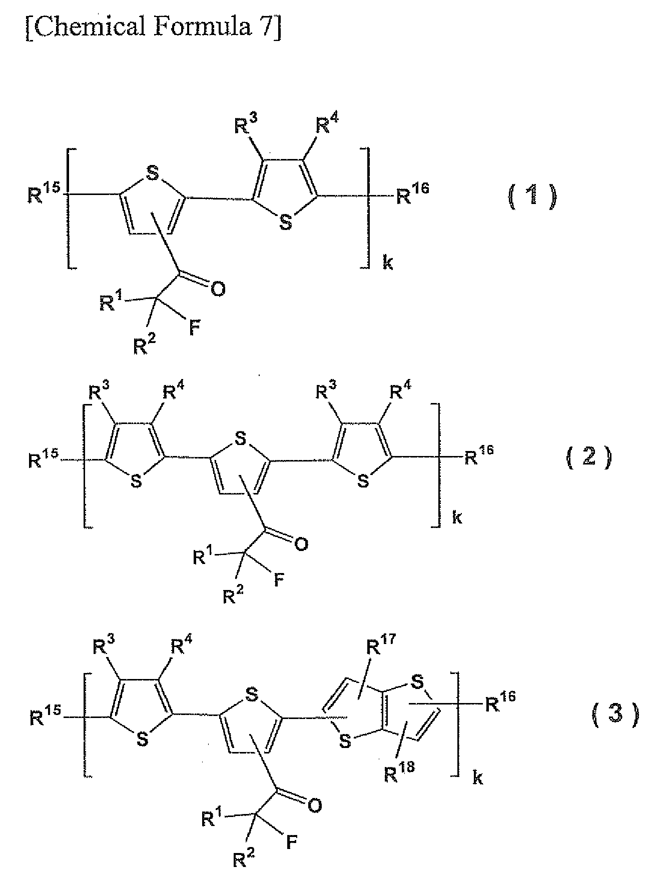

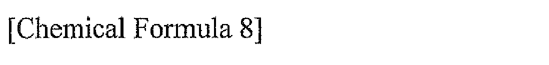

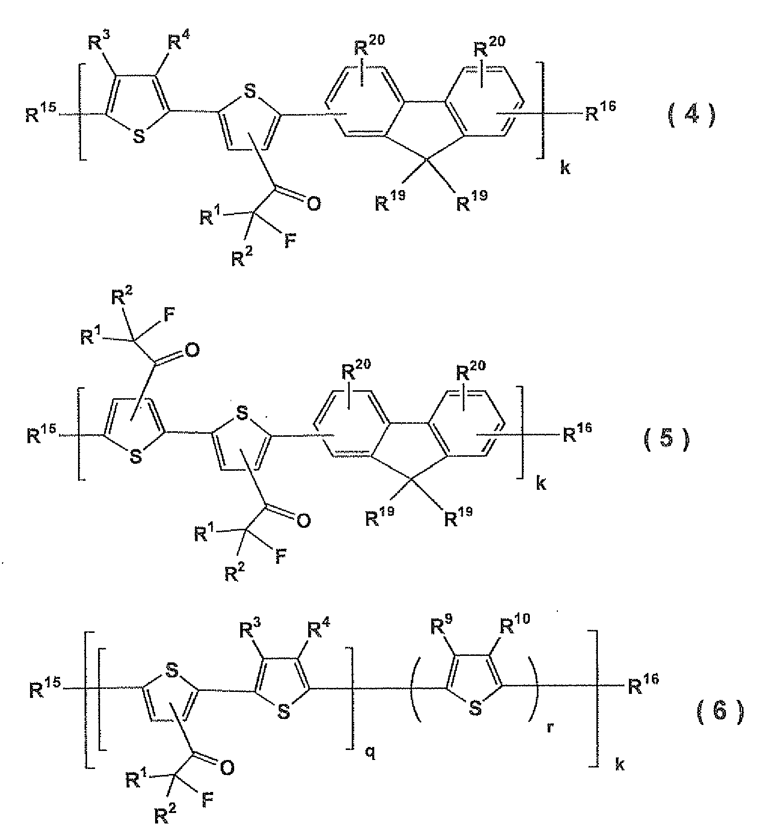

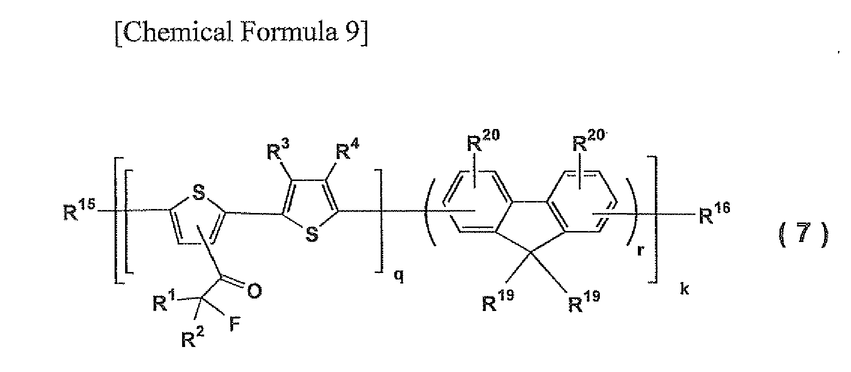

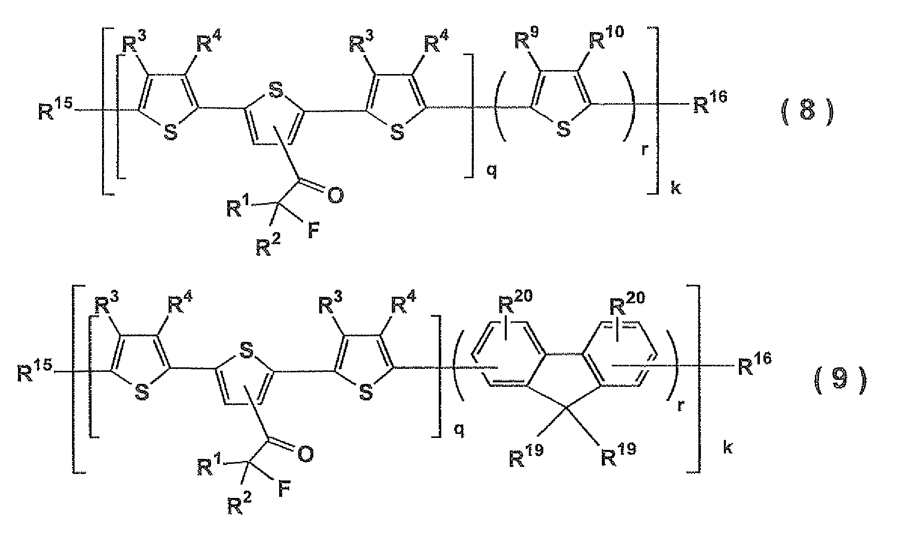

In the formulas (1) to (9), all R¹ R², R³, R⁴, k, q and r have the same meanings as defined hereinabove. R⁹ and R¹⁰ are the same or different and are each a hydrogen atom or a monovalent group; and examples of a monovalent group, include the same groups named with respect to R¹ and R². R¹⁵ and R¹⁶ are the same or different and are each any of the afore-described terminal groups, and a phenyl group is preferable. R¹⁷, R¹⁸, R¹⁹ and R²⁰ are the same or different and each mean a hydrogen atom or a monovalent group; and an alkyl group, an alkoxy group and an aryl group are preferable, and an alkyl group is further preferable. If a plurality of groups expressed by the same reference sign is present in a structure of a fluorine-containing polymer, the groups expressed by the same reference sign may be the same or different. From the viewpoint of easier production of the fluorine-containing polymer, however, the plurality of the groups expressed by the same reference sign present are preferably of the identical group.

k can be selected appropriately depending on a method for forming an organic thin film using the fluorine-containing polymer. If an organic thin film is formed, for example, by a method of coating a solution of the fluorine-containing polymer dissolved in an organic solvent, k is preferably an integer of 3 to 500, more preferably an integer of 6 to 300, and further preferably an integer of 20 to 200. From the viewpoint of attaining good homogeneity of the film when formed by coating, a number average molecular weight of a fluorine-containing polymer reduced to polystyrene is preferably 1×10³ to 1×10⁷, and more preferably 1×10⁴ to 1×10⁶.

### [Method for producing fluorine-containing polymer]

Next, a preferred embodiment with respect to a method for producing the fluorine-containing polymer as mentioned above will be described.

The fluorine-containing polymer can be produced by separately preparing a starting compound with a structure represented by the formula (I) and, according to need, a starting compound with a structure represented by the formula (II) and reacting these starting compounds to form a polymer. Examples of the starting compound with a structure represented by the formula (I) include compounds represented by formula (X), and examples of the starting compound with a structure represented by the formula (II) include compounds represented by formula (XI).

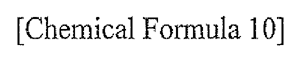

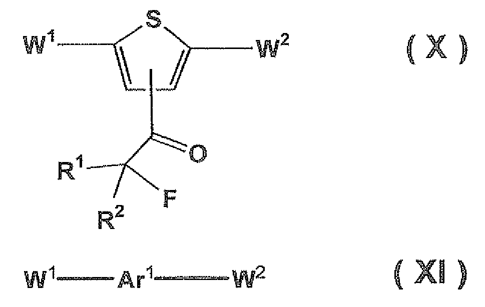

The fluorine-containing polymer can be obtained by combining according to need the starting compounds and reacting the same. To produce a fluorine-containing polymer, for example, as formulas (VI), (VII), (VIII) or (IX), including in a repeating structure a plurality of kinds of structure represented by formula (II) in combination, a plurality of kinds of starting compounds represented by the formula (XI) should be used. In this case, in order to obtain a desired structure of a fluorine-containing polymer, only a part of the starting compounds may be reacted in advance to prepare a starting compound with a uniform structure (an intermediate starting compound), which is further reacted with other starting compounds to obtain the fluorine-containing polymer.

Examples of the intermediate starting compound include such compounds as represented by formulas (XII), (XIII), and (XIV).

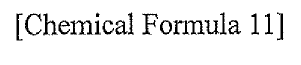

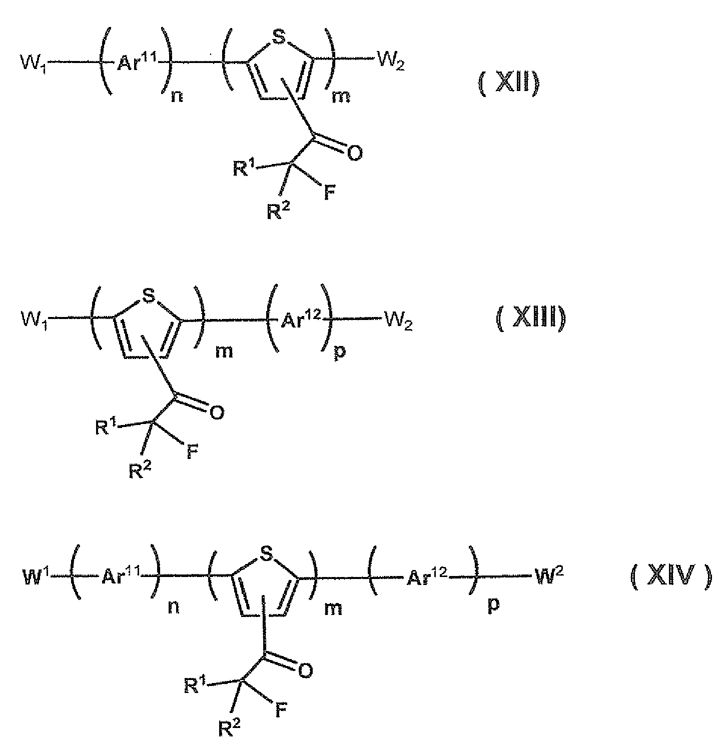

In the formulas (X) to (XIV), all R¹, R², Ar¹ Ar¹¹, Ar¹², n, m and p have the same meanings as defined hereinabove. W¹ and W² are the same or different and are each a reactive group; and examples thereof include a halogen atom, an alkylsulfonate group, an aryl sulfonate group, an arylalkyl sulfonate group, an alkylstannyl group, an arylstannyl group, an arylalkylstannyl group, a boric acid ester residue, a sulfonium methyl group, a phosphonium methyl group, a phosphonate methyl group, a monohalogenated methyl group, a boric acid residue (i.e. a group represented by -B(OH)₂), a formyl group, and a vinyl group. Examples of the boric acid ester residue include groups represented by formulas (100a) to (100f).

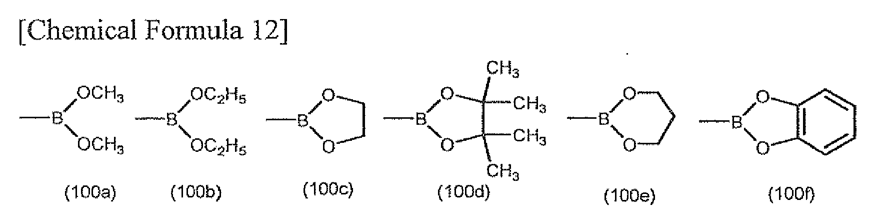

Among them, W¹ and W² are the same or different, and are each preferably a halogen atom, an alkylsulfonate group, an arylsulfonate group, an arylalkylsulfonate group, an alkylstannyl group, a boric acid ester residue or a boric acid residue from the viewpoint of good reactivity.

Examples of methods for reacting starting compounds (inclusive of an intermediate starting compound) include a method using a Wittig reaction, a method using a Heck reaction, a method using a Horner-Wadsworth-Emmons reaction, a method using a Knoevenagel reaction, a method using a Suzuki coupling reaction, a method using a Grignard reaction, a method using a Stille reaction, a method using a Ni (0) catalyst, a method using an oxidizing agent such as FeCl₃, a method using an electrochemical oxidation reaction, and a method utilizing degradation of an intermediate compound with a suitable leaving group. These may be selected in accordance with the kind of a reactive functional group which a starting compound possesses.

Among them a method using a Wittig reaction, a method using a Heck reaction, a method using a Horner-Wadsworth-Emmons reaction, a method using a Knoevenagel reaction, a method using a Suzuki coupling reaction, a method using a Grignard reaction, a method using a Stille reaction, and a method using a Ni (0) catalyst are preferable because of easier controllability on a structure of a fluorine-containing polymer. Especially, a method using a Suzuki coupling reaction, a method using a Grignard reaction, a method using a Stille reaction, a method using a Ni (0) catalyst are preferable, because starting materials suitable for the reactions are easily available and reaction procedures can be simplified.

Starting compounds are dissolved in an organic solvent according to need, and can be reacted using further an alkali or a suitable catalyst. In this case, the reaction is conducted preferably at a temperature from a melting point to a boiling point of the organic solvent.

Subject to the kind of a starting compound or a reaction to be used, it is generally preferable to use an organic solvent, which has been treated thoroughly for deoxygenation for suppressing a side reaction, and to carry out the reaction in an inert atmosphere using the same. And from a similar viewpoint, an organic solvent which has been treated for dehydration is also preferable (provided that this is not required for a reaction in a 2-phase system involving water as in the case of a Suzuki coupling reaction). An alkali or a suitable catalyst may be selected depending on a reaction. The alkali or suitable catalyst should be preferably soluble adequately in a solvent to be used for a reaction.

When a fluorine-containing polymer obtained according to the producing method is used as a material for an organic thin film element, its purity may sometimes influence an element property. Consequently from the viewpoint of attaining good purity, it is preferable to purify a starting compound prior to the reaction using a method, such as distillation, sublimation purification, and recrystallization. After a synthesis, also an obtained fluorine-containing polymer should be preferably subjected to a purification treatment, such as reprecipitation purification, and separation by chromatography.

Examples of the solvent to be used for the reaction include a saturated hydrocarbon, such as pentane, hexane, heptane, octane, and cyclohexane; an unsaturated hydrocarbon, such as benzene, toluene, ethylbenzene, and xylene; a halogenated saturated hydrocarbon, such as carbon tetrachloride, chloroform, dichloromethane, chlorobutane, bromobutane, chloropentane, bromopentane, chlorohexane, bromohexane, chlorocyclohexane, and bromocyclohexane; a halogenated unsaturated hydrocarbon, such as chlorobenzene, dichlorobenzene, and trichlorobenzene; an alcohol, such as methanol, ethanol, propanol, isopropanol, butanol, and t-butyl alcohol; a carboxylic acid, such as formic acid, acetic acid, and propionic acid; an ether, such as dimethyl ether, diethyl ether, methyl t-butyl ether, tetrahydrofuran, tetrahydropyran, and dioxane; and an inorganic acid, such as hydrochloric acid, hydrobromic acid, hydrofluoric acid, sulfuric acid, and nitric acid. One kind of these solvents may be used singly, or 2 or more kinds may be used in combination.

After the reaction the fluorine-containing polymer can be recovered by conducting conventional after-treatments, for example by quenching by water, extracting by an organic solvent, and distilling off the solvent. Isolation and purification of the product can be conducted by a method, such as separation by chromatography, and recrystallization.

### [Organic thin film]

Next an organic thin film with respect to a preferred embodiment will be described. An organic thin film includes the above described fluorine-containing polymer.

A thickness of an organic thin film is preferably 1 nm to 100 µm, more preferably 2 nm to 1000 nm, further preferably 5 nm to 500 nm, and especially preferably 20 nm to 200 nm.

An organic thin film may include a kind of fluorine-containing polymer singly, or include 2 or more kinds of fluorine-containing polymers. It may include in addition to fluorine-containing polymer(s) an electron transport material or a hole transport material, so as to improve an electron transport property or a hole transport property.

Examples of the hole transport material include a pyrazoline derivative, an arylamine derivative, a stilbene derivative, a triaryldiamine derivative, oligothiophene and a derivative thereof, polyvinylcarbazole and a derivative thereof, polysilane and a derivative thereof, a polysiloxane derivative having an aromatic amine in a side chain or a main chain, polyaniline and a derivative thereof, polythiophene and a derivative thereof, polypyrrole and a derivative thereof, polyarylene vinylene and a derivative thereof, and polythienylene vinylene and a derivative thereof.

Examples of the electron transport material include an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, polyquinoline and a derivative thereof, polyquinoxaline and a derivative thereof, polyfluorene and a derivative thereof, C60 or other fullerenes and a derivative thereof.

An organic thin film may include a charge generation material in order to generate an electric charge by absorbed light in the organic thin film. Examples of the charge generation material include an azo compound and a derivative thereof, a diazo compound and a derivative thereof, a metal-free phthalocyanine compound and a derivative thereof, a metal phthalocyanine compound and a derivative thereof, a perylene compound and a derivative thereof, a polycyclic quinone compound and a derivative thereof, a squarylium compound and a derivative thereof, an azlenium compound and a derivative thereof, a thiapyrylium compound and a derivative thereof, C60 or other fullerenes and a derivative thereof.

An organic thin film may include another material required for exhibiting various functions. Examples of such other material include a sensitizer for intensifying a function to generate an electric charge by absorbed light, a stabilizer for improving stability, and a UV absorber for absorbing UV light.

Further, an organic thin film may include as a polymeric binder a polymeric compound other than the fluorine-containing polymer to improve a mechanical property. As the polymeric binder, one that does not excessively interfere with an electron transport property or a hole transport property is preferable, and one that does not absorb visible light strongly is used preferably.

Examples of such a polymeric binder include poly(N-vinylcarbazole), polyaniline and a derivative thereof, polythiophene and a derivative thereof, poly(p-phenylene vinylene) and a derivative thereof, poly(2,5-thienylene vinylene) and a derivative thereof, polycarbonate, polyacrylate, polymethyl acrylate, polymethyl methacrylate, polystyrene, polyvinyl chloride, and polysiloxane.

Examples of a method for producing an organic thin film according to the present embodiment include a method of forming a film from a solution containing a fluorine-containing polymer as well as, according to need, an electron transport material, a hole transport material, a polymeric binder, etc., which may be mixed in a solvent. Further, if a fluorine-containing polymer has a sublimating nature, an organic thin film can be formed by a vacuum deposition method.

As a solvent to be used for forming a film from a solution, such solvent as can dissolve a fluorine-containing polymer, as well as other material is acceptable, and examples thereof include an unsaturated hydrocarbon solvent, such as toluene, xylene, mesitylene, tetralin, decalin, bicyclohexyl, n-butylbenzene, sec-butylbenzene, and tert-butylbenzene; a halogenated saturated hydrocarbon solvent, such as carbon tetrachloride, chloroform, dichloromethane, dichloroethane, chlorobutane, bromobutane, chloropentane, bromopentane, chlorohexane, bromohexane, chlorocyclohexane, and bromocyclohexane; a halogenated unsaturated hydrocarbon solvent, such as chlorobenzene, dichlorobenzene, and trichlorobenzene; an ether solvent, such as tetrahydrofuran, and tetrahydropyran. The fluorine-containing polymer can be dissolved in the solvent at 0.1 wt% or higher, and more preferably 0.5 wt% or higher, subject to a structure or a molecular weight thereof.

As a method for forming a film using a solution can be used a coating method, such as a spin coating method, a casting method, a microgravure coating method, a gravure coating method, a bar coating method, a roll coating method, a wire bar coating method, a dip coating method, a spray coating method, a screen printing method, a flexo printing method, an offset printing method, an ink jet printing method, a dispenser printing method, a nozzle coating method, and a capillary coating method. Among them, a spin coating method, a flexo printing method, an ink jet printing method, a dispenser printing method, a nozzle coating method and a capillary coating method are preferable.

Further, a process of producing an organic thin film may include a step of orienting a fluorine-containing polymer. Since in an organic thin film whose fluorine-containing polymer is oriented at the step, main chain molecules or side chain molecules align in one direction, electric charge (electron or hole) mobility may sometimes improve.

As a method for orienting a fluorine-containing polymer, a method which is known as a method for orienting a liquid crystal can be used. Among others a rubbing method, a photo-orientation method, a shearing method (shearing stress application method), and a vertical dip coating method are simple, useful and user-friendly as an orientation technique, and a rubbing method and a shearing method are preferable.

### [Organic thin-film element]

Since an organic thin film according to the embodiment described above includes a fluorine-containing polymer according to the afore-described embodiment, it has an excellent electric charge (electron or hole) transport property. Consequently, the organic thin film can transport efficiently an electron or a hole injected from an electrode or the like, or an electric charge generated by light absorption or the like, and is applicable to various electrical elements (organic thin-film elements) using an organic thin film. Since a fluorine-containing polymer according to the afore-described embodiment also has high environmental stability with high resistance to doping of oxygen, by forming a thin film using the same, an organic thin-film element whose performance is stable even in the normal atmosphere can be produced. Examples of an organic thin-film element will be described below, respectively.

### (Organic thin film transistor)

An organic thin film transistor with respect to a preferred embodiment will be described. An organic thin film transistor is required to have a structure provided with a source electrode, a drain electrode, an organic semiconductor layer, which forms a current pathway between the electrodes, and includes the afore-described fluorine-containing polymer, (i.e. an active layer, the same applies hereinbelow), and a gate electrode to control the amount of current through the current pathway. Examples of the transistor include a field effect type, and a static induction type.

A field effect type organic thin film transistor comprises preferably a source electrode, a drain electrode, an organic semiconductor layer, which forms a current pathway between the electrodes, containing a fluorine-containing polymer, a gate electrode to control the amount of current through the current pathway, and an insulating layer placed between the organic semiconductor layer and the gate electrode. Especially, it is preferable that a source electrode and a drain electrode be arranged in contact with an organic semiconductor layer containing a fluorine-containing polymer, and that a gate electrode be placed intercalating an insulating layer adjacent to the organic semiconductor layer.

It is preferable that a static induction type organic thin film transistor comprise a source electrode, a drain electrode, an organic semiconductor layer, which forms a current pathway between the electrodes, containing a fluorine-containing polymer, and a gate electrode to control the amount of current through the current pathway, and that the gate electrode be placed in an organic semiconductor layer. Especially it is preferable that the source electrode, the drain electrode and the gate electrode placed in the organic semiconductor layer be arranged in contact with the organic semiconductor layer containing the fluorine-containing polymer. There is no restriction on the structure of a gate electrode, as long as a structure makes it possible that a current pathway from a source electrode to a drain electrode is established and that the amount of current flowing through the current pathway can be controlled by applied voltage to the gate electrode, and, for example, an interdigital electrode can be named.

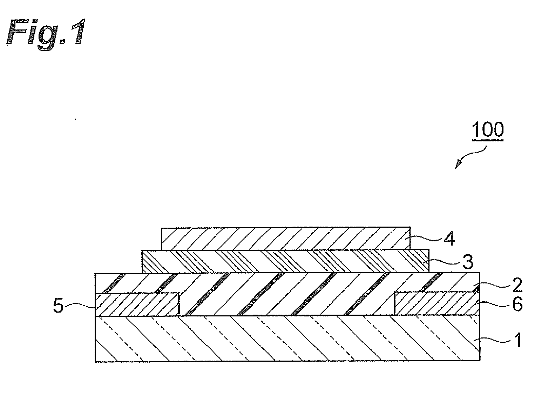

Figure 1 is a schematic sectional view of an organic thin film transistor (a field effect organic thin film transistor) according to the first embodiment. An organic thin film transistor 100 depicted in Figure 1 is provided with a substrate 1, a source electrode 5 and a drain electrode 6 formed on the substrate 1 with fixed spacing, an organic semiconductor layer 2 formed on the substrate 1 covering the source electrode 5 and the drain electrode 6, an insulating layer 3 formed on the organic semiconductor layer 2, and a gate electrode 4 formed on the insulating layer 3 covering a zone of the insulating layer 3 between the source electrode 5 and the drain electrode 6.

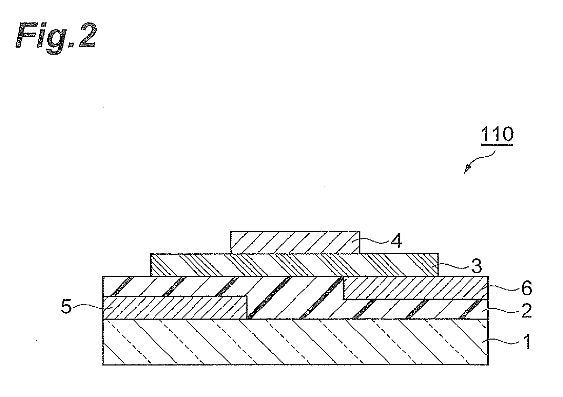

Figure 2 is a schematic sectional view of an organic thin film transistor (a field effect organic thin film transistor) according to the second embodiment. An organic thin film transistor 110 depicted in Figure 2 is provided with a substrate 1, a source electrode 5 formed on the substrate 1, an organic semiconductor layer 2 formed on the substrate 1 covering the source electrode 5, a drain electrode 6 formed on the organic semiconductor layer 2 with fixed spacing to the source electrode 5, an insulating layer 3 formed on the organic semiconductor layer 2 and the drain electrode 6, and a gate electrode 4 formed on the insulating layer 3 covering a zone of the insulating layer 3 between the source electrode 5 and the drain electrode 6.

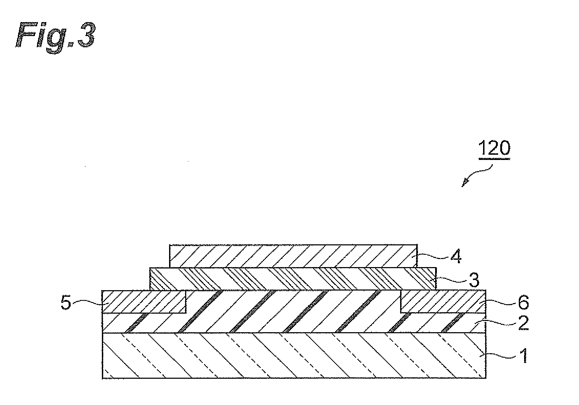

Figure 3 is a schematic sectional view of an organic thin film transistor (a field effect organic thin film transistor) according to the third embodiment. An organic thin film transistor 120 depicted in Figure 3 is provided with a substrate 1, an organic semiconductor layer 2 formed on the substrate 1, a source electrode 5 and a drain electrode 6 formed on the organic semiconductor layer 2 with fixed spacing, an insulating layer 3 formed on the organic semiconductor layer 2 covering partly the source electrode 5 and the drain electrode 6, and a gate electrode 4 formed on the insulating layer 3 covering partly each of a zone of the insulating layer 3, under which the source electrode 5 is formed, and a zone of the insulating layer 3, under which the drain electrode 6 is formed.

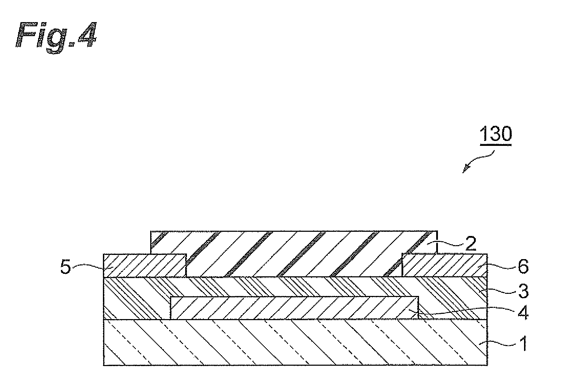

Figure 4 is a schematic sectional view of an organic thin film transistor (a field effect organic thin film transistor) according to the fourth embodiment. An organic thin film transistor 130 depicted in Figure 4 is provided with a substrate 1, a gate electrode 4 formed on the substrate 1, an insulating layer 3 formed on the substrate 1 covering the gate electrode 4, a source electrode 5 and a drain electrode 6 formed on the insulating layer 3 with fixed spacing covering partly zones of the insulating layer 3 under which the gate electrode 4 is formed, and an organic semiconductor layer 2 formed on the insulating layer 3 covering partly the source electrode 5 and the drain electrode 6.

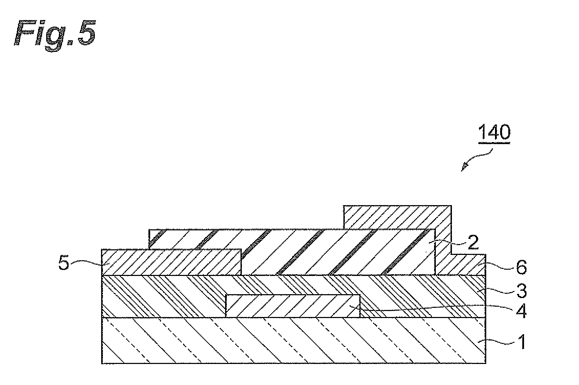

Figure 5 is a schematic sectional view of an organic thin film transistor (a field effect organic thin film transistor) according to the fifth embodiment. An organic thin film transistor 140 depicted in Figure 5 is provided with a substrate 1, a gate electrode 4 formed on the substrate 1, an insulating layer 3 formed on the substrate 1 covering the gate electrode 4, a source electrode 5 formed on the insulating layer 3 covering partly a zone of the insulating layer 3, under which the gate electrode 4 is formed, an organic semiconductor layer 2 formed on the insulating layer 3 covering partly the source electrode 5, and a drain electrode 6 formed on the insulating layer 3 with fixed spacing to the source electrode 5 covering partly a zone of the organic semiconductor layer 2.

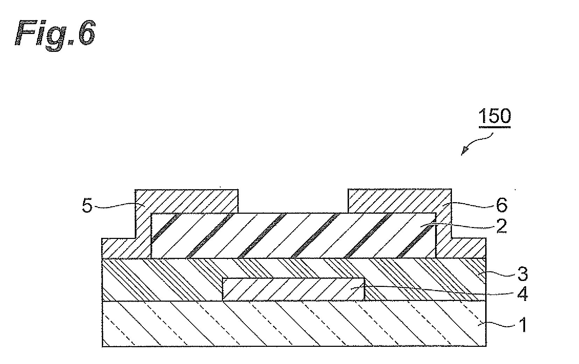

Figure 6 is a schematic sectional view of an organic thin film transistor (a field effect organic thin film transistor) according to the sixth embodiment. An organic thin film transistor 150 depicted in Figure 6 is provided with a substrate 1, a gate electrode 4 formed on the substrate 1, an insulating layer 3 formed on the substrate 1 covering the gate electrode 4, an organic semiconductor layer 2 formed covering partly a zone of the insulating layer 3, under which the gate electrode 4 is formed, a source electrode 5 formed on the insulating layer 3 covering partly a zone of the organic semiconductor layer 2, and a drain electrode 6 formed on the insulating layer 3 with fixed spacing to the source electrode 5 covering partly a zone of the organic semiconductor layer 2.

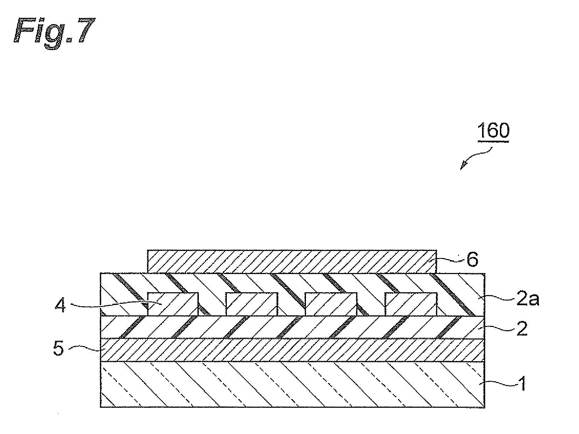

Figure 7 is a schematic sectional view of an organic thin film transistor (a static induction organic thin film transistor) according to the seventh embodiment. An organic thin film transistor 160 depicted in Figure 7 is provided with a substrate 1, a source electrode 5 formed on the substrate 1, an organic semiconductor layer 2 formed on the source electrode 5, a plurality of gate electrodes 4 formed on the organic semiconductor layer 2 with fixed spacing, an organic semiconductor layer 2a formed on the organic semiconductor layer 2 covering all the gate electrodes 4 (a material constituting the organic semiconductor layer 2a may be identical to or different from the organic semiconductor layer 2), and a drain electrode 6 formed on the organic semiconductor layer 2a.

With respect to an organic thin film transistor according to the first to seventh embodiment, an organic semiconductor layer 2 and/or an organic semiconductor layer 2a contains a fluorine-containing polymer according to the afore-described embodiment and constitutes a current channel between a source electrode 5 and a drain electrode 6. A gate electrode 4 controls the amount of current flowing through the current channel in the organic semiconductor layer 2 and/or the organic semiconductor layer 2a by means of applying voltage.

Such a field effect organic thin film transistor can be produced by a commonly known method, e.g. a method disclosed in Japanese Patent Application Laid-Open Publication No. 5-110069. While, a static induction organic thin film transistor can be produced by a commonly known method, e.g. a method disclosed in Japanese Patent Application Laid-Open Publication No. 2004-006476.

There is no restriction on a substrate 1 insofar as it does not interfere with characteristics of an organic thin film transistor, and a glass substrate, and a flexible film substrate or plastic substrate can be utilized.

For formation of an organic semiconductor layer 2, it is advantageous from the standpoint of production and preferable to use a compound soluble in an organic solvent. Therefore, using a method for producing an organic thin film by coating a solution using a fluorine-containing polymer as described above, an organic thin film constituting an organic semiconductor layer 2 can be formed. By this means, even if a thin and relatively large area organic semiconductor layer 2 is formed, homogenous quality can be attained.

There is no restriction on an insulating layer 3 adjacent to an organic semiconductor layer 2, insofar as it is an electrically highly insulating material, and a commonly known material can be used. Examples thereof include SiOx, SiNx, Ta₂O₅, polyimide, polyvinyl alcohol, polyvinylphenol, an organic glass and a photoresist. From the viewpoint of a lower voltage operation, a material having a high dielectric constant is preferable.

If an organic semiconductor layer 2 is formed on an insulating layer 3, in order to improve an interface property between the insulating layer 3 and the organic semiconductor layer 2, it is also possible to treat a surface of the insulating layer 3 for surface modification with a surface treatment agent such as a silane coupling agent, and then to form the organic semiconductor layer 2. Examples of the surface treatment agent include long chain alkylchlorosilanes, long chain alkylalkoxysilanes, fluorinated alkylchlorosilanes, fluorinated alkylalkoxysilanes, and a silyl amine compound such as hexamethyldisilazane. It is further possible to pretreat a surface of the insulating layer with ozone/UV, and O₂ plasma prior to the treatment with a surface treatment agent.

After production of an organic thin film transistor, it is possible to form a protective coat over the organic thin film transistor to protect the element. By this means the organic thin film transistor can be blocked from the air to suppress reduction in characteristics of the organic thin film transistor. Further, by the protective coat, influence of a step for forming on the organic thin film transistor a display device to be driven by the transistor can be mitigated.

Examples of a method for forming a protective coat include a method of covering with a UV curing resin, a heat curing resin, or an inorganic SiONx film. To block the air effectively, it is preferable to conduct steps from the completion of the production of an organic thin film transistor to the formation of a protective coat without exposing to the air (e.g. in a dry nitrogen atmosphere, or in vacuum).

### (Solar cell)

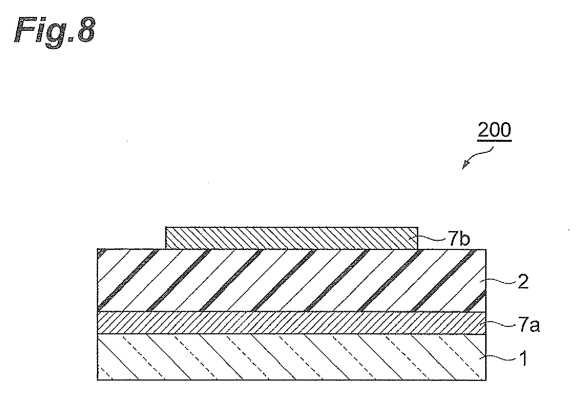

Next, application of an organic thin film according to the present invention to a solar cell will be described. Figure 8 is a schematic sectional view of a solar cell according to an embodiment. A solar cell 200 depicted in Figure 8 is provided with a substrate 1, the first electrode 7a formed on the substrate 1, an organic semiconductor layer 2 formed on the first electrode 7a, the layer being constituted of an organic thin film containing the fluorine-containing polymer, and the second electrode 7b formed on the organic semiconductor layer 2.

In the solar cell according to the present embodiment, one of the first electrode 7a and the second electrode 7b uses a transparent or translucent electrode. As an electrode material a metal, such as aluminium, gold, silver, copper, an alkali metal, and an alkaline-earth metal, as well as a translucent film, and a transparent conductive film thereof can be used. To attain high open voltage, the respective electrodes are preferably selected so as to enlarge a difference of work functions. In an organic semiconductor layer 2 (an organic thin film) a charge generation agent, a sensitizer, etc. may be added and used in order to enhance photosensitivity. As a substrate 1 a silicon substrate, a glass substrate, a plastic substrate, etc. can be utilized.

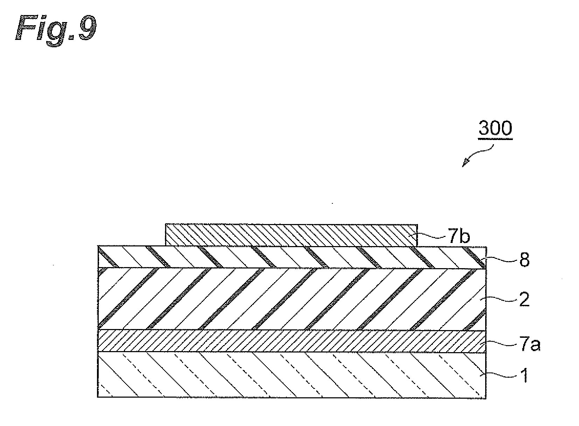

Next, application of an organic thin film according to the present invention to a photosensor will be described. Figure 9 is a schematic sectional view of a photosensor according to the first embodiment. A photosensor 300 depicted in Figure 9 is provided with a substrate 1, the first electrode 7a formed on the substrate 1, an organic semiconductor layer 2 formed on the first electrode 7a, the layer being constituted of an organic thin film containing the fluorine-containing polymer, a charge generation layer 8 formed on the organic semiconductor layer 2 and the second electrode 7b formed on the charge generation layer 8.

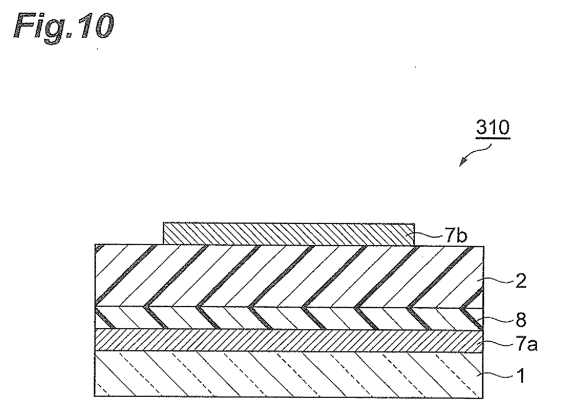

Figure 10 is a schematic sectional view of a photosensor according to the second embodiment. A photosensor 310 depicted in Figure 10 is provided with a substrate 1, the first electrode 7a formed on the substrate 1, a charge generation layer 8 formed on the first electrode 7a, an organic semiconductor layer 2 formed on the charge generation layer 8, the semiconductor layer being constituted of an organic thin film containing the fluorine-containing polymer, and the second electrode 7b formed on the organic semiconductor layer 2.

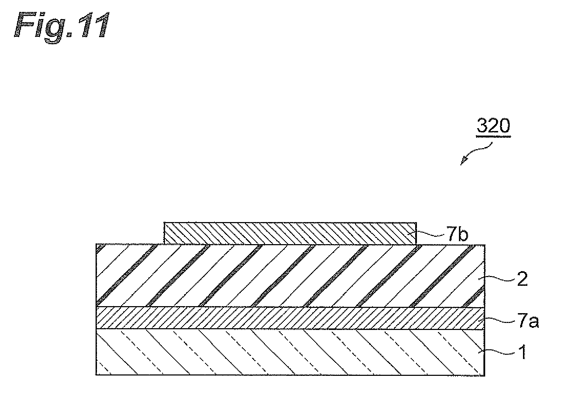

Figure 11 is a schematic sectional view of a photosensor according to the third embodiment. A photosensor 320 depicted in Figure 11 is provided with a substrate 1, the first electrode 7a formed on the substrate 1, an organic semiconductor layer 2 formed on the first electrode 7a, the layer being constituted of an organic thin film containing the fluorine-containing polymer, and the second electrode 7b formed on the organic semiconductor layer 2.

In the photosensor according to the first to third embodiments, one of the first electrode 7a and the second electrode 7b uses a transparent or translucent electrode. A charge generation layer 8 is a layer, which generates an electric charge by absorbing light. As an electrode material a metal, such as aluminium, gold, silver, copper, an alkali metal, and an alkaline-earth metal, as well as a translucent film, and a transparent conductive film thereof can be used. In an organic semiconductor layer 2 (an organic thin film) a carrier generator, a sensitizer, etc. may be added and used in order to enhance photosensitivity. As a substrate 1 a silicon substrate, a glass substrate, a plastic substrate, etc. can be utilized.

### Examples

The present invention will be described in more detail below according to Examples and Comparative Examples of the present invention, provided that the present invention be not limited to these Examples.

### (Measurement conditions)

Conditions of measurements carried out in the following Examples and Comparative Examples will be shown.

A nuclear magnetic resonance (NMR) spectrum was measured by JMN-270 (trade name) by JEOL Ltd. (270 MHz in measuring ¹H), or by JMN LA-600 (trade name) by the same company (600 MHz in measuring ¹⁹F). Chemical shifts are expressed in parts per million (ppm). As an internal standard (0 ppm) tetramethylsilane (TMS) was used. A coupling constant (J) is expressed in Hertz (Hz), and the abbreviations of s, d, t, q, m and br stand for a singlet, a doublet, a triplet, a quartet, a multiplet and a broad line, respectively.

A mass spectrometric analysis (MS) was carried out by GCMS-QP5050A (trade name) by Shimadzu Corp. according to an electron ionization (EI) method or a direct inlet (DI) method. Further, as silica gel for column chromatography separation was used Silica gel 60N (trade name) by Kanto Chemical Co., Ltd. (40 to 50 µm). All the chemicals were JIS grades, and purchased from Wako Pure Chemical Industries, Ltd., Tokyo Chemical Industry Co., Ltd., Kanto Chemical Co., Ltd., Nacalai Tesque Inc., Sigma-Aldrich Japan K.K., or Daikin Industries Ltd.

Cyclic voltammetry was measured by a measurement apparatus "CV-50W" (trade name) by BAS, Inc. using a Pt electrode produced by BAS, Inc., a Pt wire as a counter electrode, and a Ag wire as a reference electrode. At a measurement the sweep rate was 100 mV/sec, and the scanning potential range was -2.8 to 1.6 V. A measurement of a reduction potential and an oxidation potential was conducted by dissolving completely a polymer to 1×10⁻³ mol/L, and tetrabutylammonium hexafluorophosphate (TBAPF 6) as a supporting electrolyte to 0.1 mol/L in a monofluorobenzene solvent.

### [Example 1]

### (Production of fluorine-containing polymer)

### <Synthesis of compound (A)>

Into a test tube with a cap dried by heating 2,3-dibromothiophene (3.00 g, 12.4 mmol), 5-tributylstannyl-3-hexylthiophene (4.57 g, 10.0 mmol), tetrakis(triphenylphosphine)palladium (0) (290 mg, 0.025 mmol), and toluene (20 mL) were charged, and after replacement by nitrogen refluxed for 2 days.

The obtained mixture liquid was filtrated by celite, and then concentrated under a reduced pressure. By conducting purification through a silica gel column (hexane), a compound (A) (2.42 g, yield 73%) as the target product was obtained as a yellow liquid. Analysis results and a chemical formula of the obtained compound (A) are as follows.

TLC Rf=0.6 (hexane): ¹HNMR (400MHz, CDCl₃): δ 7.24 (s), 7.16 (d, 1H, J=5.6Hz), 7.00 (d, 1H, J=5.6Hz), 2.61 (m, 2H), 1.62 (m, 2H), 1.31 (m, 6H), 0.89 (m, 3H): GC-MS (EI): m/z=329 (M⁺).

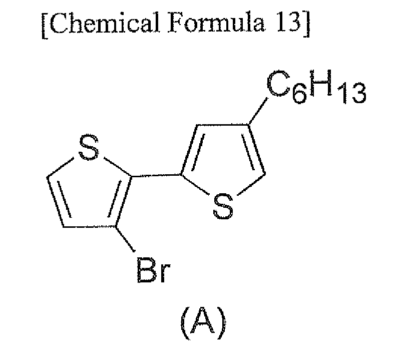

### <Synthesis of compound (B)>

Into a recovery flask dried by heating the compound (A) produced as above (785 mg, 2.38 mmol), and diethyl ether (8 mL) were charged. After replacement by nitrogen and cooling down to -78°C, n-butyllithium (1.55 M hexane solution, 1.7 mL, 2.64 mmol) was added and reacted. After 1 hour ethyl 7H-dodecafluoroheptanoate (1.07 g, 2.86 mmol) was added at -78°C and the mixture was stirred. After 1 hour water was added and the mixture was extracted by ethyl acetate.

An obtained organic layer was dried over magnesium sulfate and concentrated under a reduced pressure. By conducting purification through a silica gel column (hexane/CHCl₃=4/1, volume ratio), a compound (B) (687 mg, yield 50%) as the target product was obtained as a yellow liquid. Analysis results and a chemical formula of the obtained compound (B) are as follows.

TLC Rf=0.2 (hexane): ¹HNMR (400MHz, CDCl₃): δ 7.52 (m, 1H), 7.38 (m, 1H), 7.27 (m, 1H), 7.06 (m, 1H), 6.04 (m, 1H), 2.62 (m, 2H), 1.62 (m, 2H), 1.31 (m, 6H), 0.89 (m, 3H): GC-MS (DI): m/z=578 (M⁺).

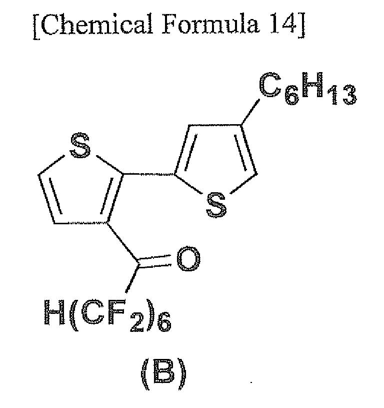

### <Synthesis of compound (C)>

Into a recovery flask dried by heating the compound (B) produced as above (147 mg, 0.254 mmol), and dimethylformamide (3 mL) were charged, then N-bromosuccinimide (110 mg, 0.611 mmol) was added at room temperature and reacted. After 16 hours water was added and the mixture was extracted by ethyl acetate.

The obtained organic layer was dried over magnesium sulfate and concentrated under a reduced pressure. By conducting purification through a silica gel column (hexane/CHCl₃=4/1, volume ratio), a compound (C) (91 mg, 49%) as the target product was obtained as an orange colored liquid. Analysis results and a chemical formula of the obtained compound (C) are as follows.

TLC Rf=0.3 (hexane): ¹HNMR (400MHz, CDCl₃): δ 7.45 (s, 1H), 7.22 (s, 1H), 6.04 (m, 1H), 2.57 (m, 2H), 1.58 (m, 2H), 1.32 (m, 6H), 0.89 (m, 3H): GC-MS (EI): m/z=736 (M⁺).

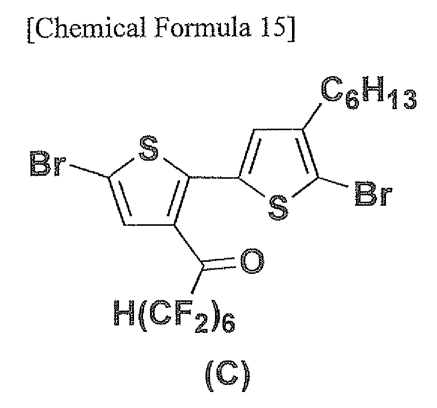

### <Synthesis of compound (D)>

Into a test tube with a cap dried by heating the compound (C) produced as above (90 mg, 0.12 mmol), bis(tributyl)tin (71 mg, 0.12 mmol), tetrakis(triphenylphosphine)palladium (0) (14 mg, 0.012 mmol), and toluene (1 mL) were charged and after replacement by nitrogen refluxed for 7 days.

Methanol was added to the obtained reaction liquid, which was centrifuged to separate a solid. By conducting purification by Soxhlet extraction (methanol, CHCl₃), a black solid polymer (D) (30 mg, yield 42%) as the target product was obtained. A number average molecular weight of the polymer (D) reduced to polystyrene was 5000, and a reduction potential was -1.71 V and an oxidation potential was 0.91 V Further, the polymer (D) could be completely dissolved in chloroform at room temperature. Analysis results and a chemical formula of the obtained polymer (D) are as follows.

¹HNMR (400MHz, CDCl₃): δ 7.55 (m), 6.06 (m), 2.79 (m), 2.62 (m), 1.59 (m), 1.28 (m), (0.86)

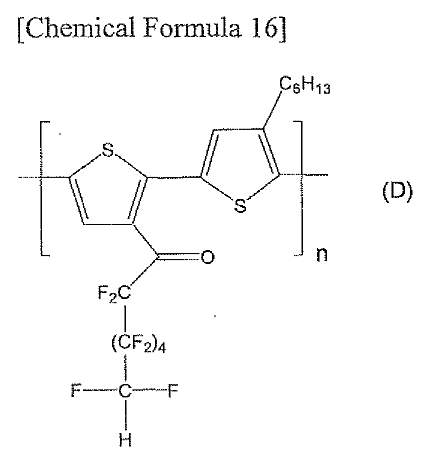

### <Production of organic thin film transistor and evaluation of transistor property >

First, a low resistivity silicon wafer with a thermally-oxidized film (silicon dioxide film) (the wafer having a constitution to become a gate electrode/an insulating layer) is dipped in and subjected to ultrasonic cleaning for each of ethanol, distilled water, and acetone in the order mentioned. Then the silicon wafer is subjected to UV-ozone cleaning to obtain a substrate having a hydrophilic surface. The substrate is dipped in hexamethyldisilazane / chloroform at room temperature, and cleaned by ultrasonic cleaning using chloroform to obtain a surface prepared substrate.

Next, a coating solution is prepared by dissolving the polymer (D) synthesized as above in chloroform. The solution is formed to a film by a spin coating method on the surface prepared substrate to form an organic thin film. An organic thin film transistor is obtained by forming gold electrodes (source electrode, drain electrode) on the organic thin film by means of vacuum deposition using a metal mask.

By measuring the obtained organic thin film transistor with respect to an organic semiconductor characteristic by changing gate voltage Vg and source-drain voltage Vsd using a semiconductor parametric analyzer ("4200-SCS" (trade name), by Keithley Instruments Inc.), a good Id-Vg characteristic of a p-type semiconductor is obtained. Even if a measurement is carried out similarly after an organic thin film transistor is left standing in the air, increase in an off-state current is limited and is stable. Therefore the polymer (D) is resistant to doping of oxygen.

### Reference Signs List

1 ... substrate, 2 ... organic semiconductor layer, 2a ... organic semiconductor layer, 3 ... insulating layer, 4 ... gate electrode, 5 ... source electrode, 6 ... drain electrode, 7a ... the first electrode, 7b ... the second electrode, 8 ... charge generation layer, 100 ... organic thin film transistor according to first embodiment, 110 ... organic thin film transistor according to second embodiment, 120 ... organic thin film transistor according to third embodiment, 130 ... organic thin film transistor according to fourth embodiment, 140 ... organic thin film transistor according to fifth embodiment, 150 ... organic thin film transistor according to sixth embodiment, 160 ... organic thin film transistor according to seventh embodiment, 200 ... solar cell according to embodiment, 300 ... photosensor according to first embodiment, 310 ... photosensor according to second embodiment, 320 ... photosensor according to third embodiment.

## Claims

1. A fluorine-containing polymer comprising a structure represented by formula (I) in a repeating unit: 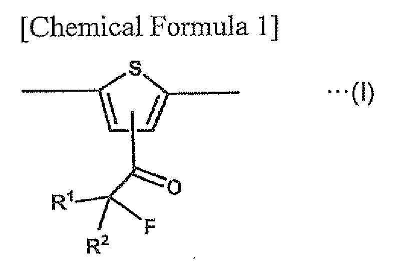 wherein R¹ and R² are the same or different and each mean a hydrogen atom or a monovalent group.

2. The fluorine-containing polymer according to claim 1, further comprising a structure represented by formula (II) in the repeating unit:
[Chemical Formula 2] -Ar¹- (II)
wherein Ar¹ means a C6 or higher divalent aromatic hydrocarbon group or a C4 or higher divalent heterocyclic group.

3. The fluorine-containing polymer according to claim 2, wherein Ar¹ is a group represented by formula (III): 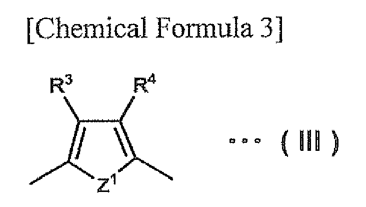 wherein R³ and R⁴ are the same or different and each mean a hydrogen atom or a monovalent group; R³ and R⁴ may be bonded together to form a ring; and Z¹ means any of groups represented by formulas (i), (ii), (iii), (iv), (v), (vi), (vii), (viii) and (ix): 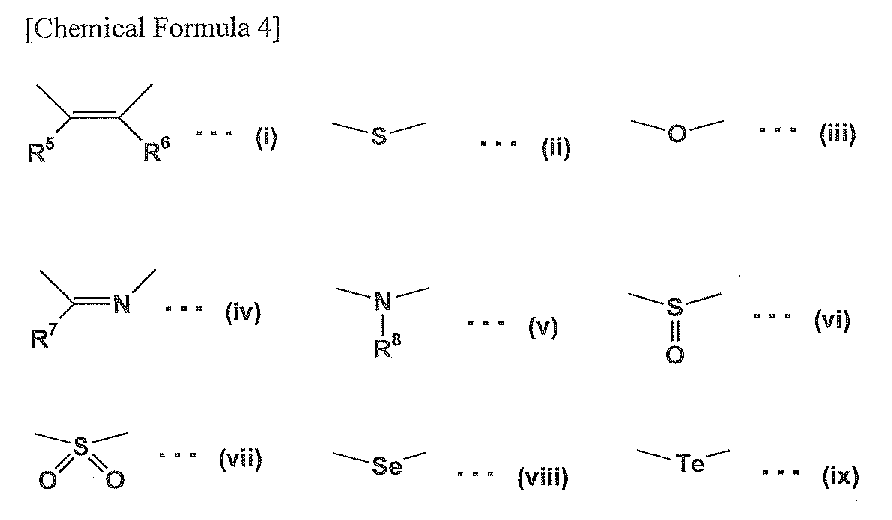 wherein R⁵, R⁶, R⁷ and R⁸ are the same or different and each mean a hydrogen atom or a monovalent group; and R⁵ and R⁶ may be bonded together to form a ring, and a group represented by the formula (iv) may be reversed from left to right.

4. The fluorine-containing polymer according to claim 3, wherein the Z¹ is a group represented by the formula (ii).

5. The fluorine-containing polymer according to any one of claims 1 to 4, wherein the R¹ and the R² are the same or different and are each a fluorine atom, a C1 to C20 alkyl group, or a C1 to C20 fluoroalkyl group.

6. An organic thin film comprising the fluorine-containing polymer according to any one of claims 1 to 5.

7. An organic thin film element comprising the organic thin film according to claim 6.

8. An organic thin film transistor comprising a source electrode, a drain electrode, an organic semiconductor layer that forms a current pathway between the electrodes, and a gate electrode to control an amount of current through the current pathway,
wherein the organic semiconductor layer comprises the organic thin film according to claim 6.

9. An organic solar cell comprising the organic thin film according to claim 6.

10. A photosensor comprising the organic thin film according to claim 6.
